(19) Europäisches Patentamt

European Patent Office

Office européen des brevets

(11) **EP 1 592 023 A1**

(12) **DEMANDE DE BREVET EUROPEEN**

(43) Date de publication:
02.11.2005 Bulletin 2005/44

(51) Int Cl.⁷: **G11C 11/16**

(21) Numéro de dépôt: 05103286.0

(22) Date de dépôt: **22.04.2005**

(84) Etats contractants désignés:
**AT BE BG CH CY CZ DE DK EE ES FI FR GB GR HU IE IS IT LI LT LU MC NL PL PT RO SE SI SK TR**
Etats d'extension désignés:
**AL BA HR LV MK YU**

(30) Priorité: **26.04.2004  FR 0450779**

(71) Demandeurs:
• **STMicroelectronics S.A.**
  **92120 Montrouge (FR)**
• **CENTRE NATIONAL DE**
  **LA RECHERCHE SCIENTIFIQUE (CNRS)**
  **75794 Paris Cedex 16 (FR)**
• **Université de Paris-Sud XI**
  **91405 Orsay Cedex (FR)**

(72) Inventeurs:
• **KIM, Joo-Von**
  **91300, MASSY (FR)**
• **Devolder, Thibaut**
  **91300 MASSY (FR)**
• **CHAPPERT, Claude**
  **92380, GARCHES (FR)**
• **MAUFRONT, Cédric**
  **38000, GRENOBLE (FR)**
• **FOURNEL, Richard**
  **38660, LUMBIN (FR)**

(74) Mandataire: **de Beaumont, Michel et al**
**Cabinet Michel de Beaumont**
**1, rue Champollion**
**38000 Grenoble (FR)**

(54) **Elément de mémoire vive magnétique**

(57)     L'invention concerne un élément mémoire magnétorésistif (16) comprenant une région magnétique piégée (22) et une région magnétique libre (18) séparées par une couche barrière (20). La région magnétique libre comprend un empilement d'au moins deux couches ferromagnétiques (26, 28) couplées antiferromagnétiquement, à chaque couche étant associé un vecteur moment magnétique de couche ($\vec{\mu}_1$, $\vec{\mu}_2$), le vecteur moment magnétique résultant, égal à la somme des vecteurs moment magnétique de couche, ayant une amplitude inférieure à au moins 40% de l'amplitude du vecteur moment magnétique de couche d'amplitude maximale. Le champ d'anisotropie ou le tenseur de champ démagnétisant n'est pas identique pour les deux couches ferromagnétiques d'où il résulte que les déviations angulaires des vecteurs moment magnétique de couche sont différentes au moment de l'application d'un champ magnétique extérieur, ce qui permet au moins deux procédés d'écriture directe de l'élément mémoire ainsi que son initialisation.

Fig 3

EP 1 592 023 A1

## Description

La présente invention concerne un élément de mémoire vive magnétique et notamment un élément mémoire destiné à être utilisé dans une mémoire vive magnétique (MRAM de l'anglais Magnetic Random Access Memory) comprenant une matrice d'éléments mémoire.

Un élément de mémoire vive magnétique se caractérise généralement par un vecteur moment magnétique dont l'orientation peut être modifiée par l'application d'une action d'origine extérieure, notamment un champ magnétique. Une information spécifique est stockée dans l'élément mémoire en orientant le vecteur moment magnétique selon une direction et/ou un sens privilégiés. L'élément mémoire peut conserver une information pendant une durée importante sans qu'il y ait besoin de rafraîchir l'élément mémoire ou de l'alimenter en énergie, ce qui est un avantage important de ce type de mémoire. A titre d'exemple, pour stocker une information binaire, on peut prévoir un élément mémoire ayant un axe de facile aimantation. Le vecteur moment magnétique est alors orienté le long de l'axe de facile aimantation dans un premier sens pour stocker un premier état de l'information et dans le sens opposé pour stocker un second état de l'information.

Un procédé classique de lecture d'une information stockée dans un élément de mémoire vive magnétique consiste à détecter les différences de résistance de l'élément mémoire selon l'orientation du vecteur moment magnétique. Un procédé classique d'écriture d'un élément mémoire fait intervenir des champs magnétiques d'écriture produits en faisant passer des courants à travers des pistes métalliques externes à l'élément mémoire. De manière non conventionnelle, il a été aussi proposé d'utiliser les effets produits par un courant envoyé à travers l'élément mémoire lui-même. De tels effets sont notamment : le champ magnétique créé par le courant, un effet thermique induit par effet Joule, ou un effet de transfert de moment cinétique de spin des électrons de conduction vers l'aimantation.

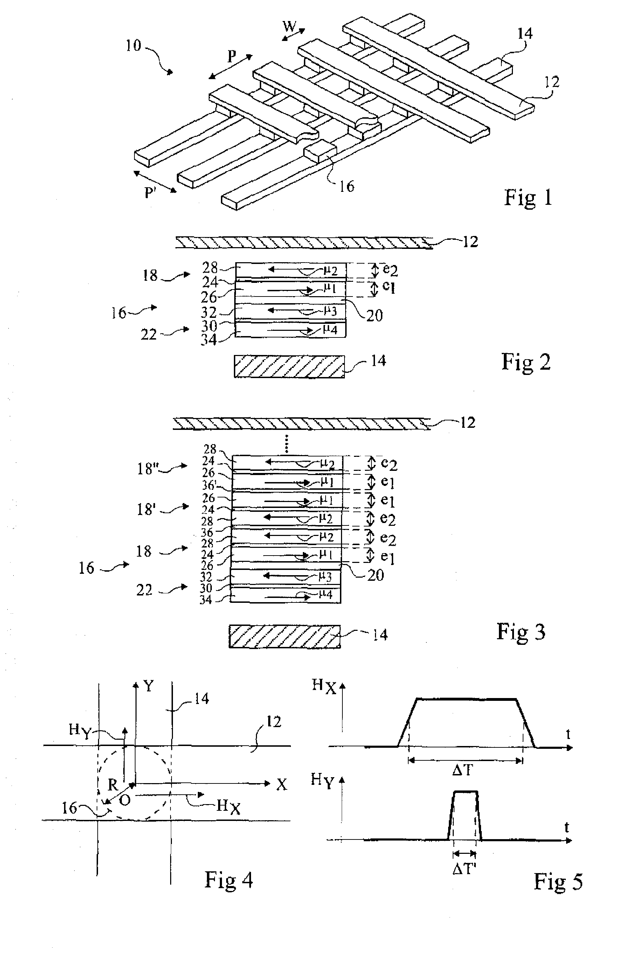

La figure 1 représente le schéma de principe d'une mémoire magnétique classique. La mémoire MRAM 10 est constituée de premières pistes d'un matériau conducteur formant des lignes de mot 12 disposées perpendiculairement à des secondes pistes d'un matériau conducteur formant des lignes de bit 14. La période p du réseau de lignes de mot 12 et la période p' du réseau de lignes de bits 14 sont généralement de l'ordre de quelques fois la largeur w d'une piste métallique et peuvent être différentes. Un élément mémoire 16 est disposé à l'intersection de chaque ligne de mot 12 et de chaque ligne de bit 14. Le processus d'écriture fait alors intervenir des champs magnétiques produits en faisant passer des courants à travers les lignes de mot 12 et les lignes de bit 14.

Un schéma réaliste d'une mémoire magnétique peut être plus complexe et faire intervenir, par exemple, pour les besoins de la lecture, une diode ou un transistor en série avec chaque élément mémoire sans influence significative sur la présente invention.

On cherche actuellement à augmenter la densité des mémoires magnétiques, c'est-à-dire à augmenter le nombre d'éléments mémoire par unité de surface. Une difficulté provient du fait que, par interaction dipolaire, le moment magnétique d'un élément mémoire considéré est susceptible de perturber le comportement d'éléments mémoire adjacents d'autant plus que la densité de la mémoire est élevée. Une perturbation se traduit par exemple par une dégradation de la fiabilité du processus d'écriture des informations dans les éléments mémoire adjacents à l'élément mémoire considéré, ou par une dégradation de la durée de conservation des informations dans les éléments mémoire adjacents.

Pour éviter un tel inconvénient, on privilégie l'utilisation d'un élément mémoire qui, au moins en l'absence d'application d'un champ magnétique extérieur, a un moment magnétique global très faible. Un tel élément mémoire est dit compensé. Un élément mémoire compensé a une influence négligeable sur les éléments mémoire adjacents dès qu'on s'éloigne de l'élément mémoire d'une distance supérieure à un faible multiple de l'épaisseur de l'élément mémoire.

La figure 2 représente schématiquement un exemple d'élément mémoire compensé, du type de l'élément mémoire décrit dans le brevet US 6 545 906.

L'élément mémoire 16 est compris entre une ligne de mot 12 et une ligne de bit 14, sans nécessité d'hypothèse particulière sur un contact éventuel entre l'élément mémoire 16 et la ligne de mot 12 et/ou la ligne de bit 14, ni sur la présence de couches supplémentaires entre l'élément mémoire 16 et la ligne de mot 12 et/ou la ligne de bit 14. A titre d'exemple, la ligne de mot 12 est placée au sommet de l'élément mémoire 16 et la ligne de bit 14 est placée à la base de l'élément mémoire 16 et est dirigée selon un angle de 90° par rapport à la ligne de mot 12.

Les régions magnétiques 18, 22 sont constituées par des structures à couches synthétiques antiferromagnétiques également appelées structures SAF (de l'anglais Synthetic Anti-Ferromagnet). Plus précisément, l'élément mémoire 16 comprend une première région magnétique 18, une couche barrière 20, et une seconde région magnétique 22, la couche barrière 20 étant prise en sandwich entre la première région magnétique 18 et la seconde région magnétique 22. La première région magnétique 18 comprend une structure à trois couches qui comporte une couche de séparation 24 prise en sandwich entre deux couches ferromagnétiques 26, 28 et qui induit un couplage antiferromagnétique entre les deux couches antiferromagnétiques 26, 28. La seconde région magnétique 22 comprend une structure à trois couches qui comporte une couche de séparation 30 prise en sandwich entre deux couches ferromagnétiques 32, 34 et qui induit un couplage antiferromagnétique entre les deux couches ferromagnétiques 32, 34. Les couches ferromagnétiques 26, 28 ont respectivement des vecteurs moment magnétique $\vec{\mu}_1$, $\vec{\mu}_2$ qui sont maintenus antiparallèles par le couplage à travers la couche de séparation 24. De façon analogue, les couches ferromagnétiques 32, 34 ont respectivement des vecteurs moment magnétique $\vec{\mu}_3$, $\vec{\mu}_4$ qui sont maintenus antiparallèles par le couplage à travers la couche de séparation 30. Chaque couche ferromagnétique peut être éventuellement constituée de plusieurs couches ferromagnétiques rigidement couplées par des interactions d'échange interfaciales.

La région magnétique 18 est appelée région magnétique libre dans la mesure où $\vec{\mu}_1$ et $\vec{\mu}_2$ sont libres de pivoter en présence d'un champ magnétique appliqué à l'élément mémoire 16. La région magnétique 22 est appelée région magnétique piégée, dans la mesure où $\vec{\mu}_3$ et $\vec{\mu}_4$ ne sont pas libres de pivoter en présence d'un champ magnétique ayant une amplitude modérée, le vecteur moment magnétique $\vec{\mu}_4$ étant fixé dans une direction privilégiée. Ce résultat est généralement obtenu par dépôt de la couche 34 sur un film antiferromagnétique qui n'a pas d'influence significative sur la présente invention. La région magnétique 22 peut donc être utilisée comme une région magnétique de référence.

Les régions magnétiques 26, 28, 32, 34 ont des axes de facile aimantation sensiblement parallèles selon lesquels s'orientent de façon privilégiée les vecteurs moment magnétique $\vec{\mu}_1$, $\vec{\mu}_2$, $\vec{\mu}_3$, $\vec{\mu}_4$. Le stockage d'une information dans un élément mémoire 16 est obtenu en orientant $\vec{\mu}_1$ en parallèle ou en antiparallèle par rapport à $\vec{\mu}_3$. La lecture de l'information stockée dans l'élément mémoire est réalisée en faisant traverser l'élément mémoire par un courant et en détectant les différences de résistance de l'élément mémoire 16 selon l'orientation de $\vec{\mu}_1$. En effet, la résistance dépend de l'orientation relative de $\vec{\mu}_1$ par rapport à $\vec{\mu}_3$.

Pour éviter que les moments magnétiques de l'élément mémoire 16 ne perturbent les éléments mémoire adjacents, les régions magnétiques 18, 22 sont compensées, c'est-à-dire que les matériaux et/ou les volumes des couches ferromagnétiques 26, 28, 32, 34 sont tels que le vecteur moment magnétique résultant $\vec{\mu}_{tot}$ de la région magnétique libre 18, égal à $\vec{\mu}_1+\vec{\mu}_2$, et le vecteur moment magnétique résultant de la région magnétique piégée 22, égal à $\vec{\mu}_3+\vec{\mu}_4$, sont sensiblement égaux au vecteur nul. Ceci permet alors d'augmenter la densité de la mémoire magnétique 10 par rapport à un élément mémoire simple dont la région magnétique libre serait constituée d'une seule couche ferromagnétique, comme c'est le cas dans un élément mémoire classique.

Par ailleurs, dans un élément mémoire compensé, la minimisation ou l'optimisation de l'interaction principalement d'origine dipolaire entre les régions magnétiques 18 et 22 doit être prise en compte dans les détails de structure de ces régions. Par souci de simplification, nous ne considérerons pas ce point dans la suite de la description, tout en ayant vérifié qu'il n'influe pas significativement sur la présente invention.

De façon classique, l'écriture d'une information dans l'élément mémoire 16 est obtenue par la production de champs magnétiques adaptés à orienter $\vec{\mu}_1$ dans une direction et un sens privilégiés. Puisque $\vec{\mu}_1$ et $\vec{\mu}_2$ sont maintenus antiparallèles par l'interaction antiferromagnétique à travers la couche 24, il est équivalent de contrôler l'orientation $\vec{\mu}_1$ ou celle de $\vec{\mu}_2$. Les champs magnétiques d'écriture sont produits par le passage de courants dans la ligne de mot 12 et la ligne de bit 14.

La définition de champs magnétiques pour l'écriture d'un seul élément mémoire 16 est un processus délicat. En effet, il faut éviter que les champs magnétiques d'écriture issus du passage de courants dans une ligne de mot 12 et une ligne de bit 14 entraînent une écriture dans d'autres éléments mémoire 16, par exemple les éléments mémoire reliés à la même ligne de mot ou à la même ligne de bit, et les éléments mémoire voisins de l'élément mémoire adressé. L'obtention de champs magnétiques d'écriture convenables est généralement encore plus difficile lorsque la région magnétique libre de l'élément mémoire a une structure compensée ou quasiment compensée puisque la modification de l'orientation des vecteurs moment magnétique de l'élément mémoire tend à requérir des champs magnétiques plus intenses en particulier pour vaincre l'interaction entre les couches de la région magnétique libre. En outre, lorsqu'on applique un champ magnétique à l'élément mémoire, il est difficile d'assurer que le moment résultant $\vec{\mu}_{tot}$ de la région magnétique libre 18 conserve pendant le processus d'écriture une amplitude suffisamment faible pour ne pas perturber les éléments mémoire adjacents.

Dans l'optique d'atteindre de très hautes densités d'intégration, deux autres phénomènes contradictoires doivent être contrôlés. Le premier consiste dans le fait que, lorsque le volume de la région magnétique libre 18 diminue, la préservation d'une durée suffisante de conservation de l'information nécessite d'augmenter l'anisotropie magnétique totale de l'échantillon, ce qui, en général, augmente l'amplitude des champs magnétiques requis pour le processus d'écriture. Le deuxième phénomène est du au fait que la densité de courant maximale admissible dans une piste conductrice est limitée par des phénomènes physiques (effet Joule, électromigration). Le courant maximal injectable pour un processus d'écriture, et le champ magnétique d'écriture qui lui est proportionnel, diminuent donc avec la section des pistes conductrices quand on augmente la densité de la mémoire.

Le document US 6 545 906 décrit un procédé d'écriture particulier d'un élément mémoire compensé ou quasiment compensé.

La présente invention vise à obtenir une structure d'élément mémoire compensée ou quasiment compensée particulière, destinée notamment à une utilisation dans une mémoire magnétique vive, permettant l'écriture directe, sans lecture préalable, d'une information dans l'élément mémoire au moyen de courants ayant des amplitudes modérées, et permettant de repousser les limites décrites précédemment pour l'obtention de hautes densités.

Pour atteindre cet objet, la présente invention prévoit un élément mémoire magnétorésistif comprenant une région magnétique piégée et une région magnétique libre séparées par une couche barrière, la région magnétique libre comprenant un empilement d'au moins deux couches ferromagnétiques couplées antiferromagnétiquement, à chaque couche étant associé un vecteur moment magnétique de couche, le vecteur moment magnétique résultant, égal à la somme des vecteurs moment magnétique de couche, ayant une amplitude inférieure à au moins 40% de l'amplitude du vecteur moment magnétique de couche d'amplitude maximale, dans lequel le champ d'anisotropie et/ou le tenseur de champ démagnétisant n'est pas identique pour les au moins deux couches ferromagnétiques d'où il résulte que les déviations angulaires des vecteurs moment magnétique de couche sont différentes au moment de l'application d'un champ magnétique extérieur.

Selon un mode de réalisation de la présente invention, la région magnétique libre comprend un empilement d'au moins deux paires de couches ferromagnétiques couplées antiferromagnétiquement, à chaque couche ferromagnétique étant associé un vecteur moment magnétique de couche, le vecteur moment magnétique résultant de chaque paire de couches, égal à la somme des vecteurs moment magnétique des couches ferromagnétiques de la paire de couches ferromagnétiques, ayant une amplitude inférieure à au moins 40% de l'amplitude du vecteur moment magnétique de couche d'amplitude maximale, les couches ferromagnétiques adjacentes des deux paires de couches ferromagnétiques étant couplées ferromagnétiquement. Le champ d'anisotropie et/ou le tenseur de champ démagnétisant n'est pas identique pour les deux couches ferromagnétiques d'au moins une paire de couches ferromagnétiques, la disposition et les propriétés des couches ferromagnétiques dans chaque paire de couches ferromagnétiques étant adaptées pour que les vecteurs moment magnétique de couche de deux couches ferromagnétiques adjacentes ferromagnétiquement couplées acquièrent des déviations angulaires identiques au moment de l'application d'un champ magnétique extérieur.

Selon un mode de réalisation de la présente invention, la région magnétique libre comprend un empilement d'au moins une première, une deuxième et une troisième couches ferromagnétiques, les première et deuxième couches ferromagnétiques étant couplées antiferromagnétiquement, les deuxième et troisième couches ferromagnétiques étant couplées antiferromagnétiquement, à chacune des première, deuxième et troisième couches ferromagnétiques étant associé un vecteur moment magnétique de couche, le vecteur moment magnétique résultant, égal à la somme des vecteurs moment magnétique de couche des première, deuxième et troisième couches ferromagnétiques, ayant une amplitude inférieure à au moins 40% de l'amplitude du vecteur moment magnétique de la deuxième couche ferromagnétique. Les champs d'anisotropie et/ ou les tenseurs de champ démagnétisant de la première ou troisième couche ferromagnétique et de la deuxième couche ferromagnétique sont différents d'où il résulte que les déviations angulaires des vecteurs moment magnétique de couche des première et troisième couches ferromagnétiques sont identiques et différents de la déviation angulaire de la deuxième couche ferromagnétique au moment de l'application d'un champ magnétique extérieur.

La présente invention prévoit également un procédé d'écriture dans un élément mémoire tel que défini précédemment, dans lequel le vecteur moment magnétique de la couche ferromagnétique de la région magnétique libre en contact avec la couche barrière est orienté selon l'une des deux orientations opposées d'une direction privilégiée, comprenant, de façon au moins partiellement simultanée, les étapes consistant à appliquer un premier champ magnétique selon la direction privilégiée ; et à appliquer un second champ magnétique selon une direction sensiblement perpendiculaire à la direction privilégiée.

Selon un mode de réalisation de la présente invention, le tenseur de champ démagnétisant et/ou le champ d'anisotropie d'origine cristallographique n'est pas identique pour les au moins deux couches ferromagnétiques, le second champ magnétique étant appliqué, pendant l'application du premier champ magnétique, sous la forme d'une impulsion dont le temps de montée est inférieur à la moitié de la période de précession la plus faible des au moins deux couches ferromagnétiques.

Selon un mode de réalisation de la présente invention, les champs d'anisotropie effectifs planaires des au moins deux couches ferromagnétiques couplées antiferromagnétiquement ont des amplitudes différentes, les premier et second champs magnétiques étant appliqués simultanément pendant une durée supérieure aux temps de relaxation des vecteurs moment magnétique de couche des au moins deux couches ferromagnétiques couplées antiferromagnétiquement de la région magnétique libre vers des positions d'équilibre respectives déterminées.

Selon un mode de réalisation de la présente invention, l'amplitude du second champ magnétique est inférieure à la moitié de l'amplitude du premier champ magnétique.

Selon un mode de réalisation de la présente invention, les instants de mise en place et/ou les durées d'application des premier et second champs magnétiques sont différents.

Selon un mode de réalisation de la présente invention, les premier et second champs magnétiques sont appliqués de manière globale à une mémoire constituée d'éléments mémoire tels que définis précédemment, en utilisant une source de champ magnétique extérieure à la mémoire, d'où il résulte l'initialisation de la mémoire.

Selon un mode de réalisation de la présente invention, les premier et second champs magnétiques sont appliqués de manière globale à une mémoire constituée d'éléments mémoire tels que définis précédemment, en utilisant une source de champ magnétique extérieure à la mémoire, d'où il résulte l'effacement complet de la mémoire.

Cet objet, ces caractéristiques et avantages, ainsi que d'autres de la présente invention seront exposés en détail dans la description suivante de modes de réalisation particuliers faite à titre non-limitatif en relation avec les figures jointes parmi lesquelles :

la figure 1, précédemment décrite, représente schématiquement une mémoire MRAM classique ;
la figure 2, précédemment décrite, représente schématiquement un exemple d'élément mémoire à structure compensée ;
la figure 3 représente schématiquement un exemple d'élément mémoire à structure compensée selon l'invention ;
la figure 4 représente schématiquement l'orientation de champs magnétiques d'écriture appliqués à un élément mémoire selon l'invention ;
la figure 5 représente une séquence d'application de champs magnétiques d'écriture selon un premier exemple de réalisation du procédé d'écriture de l'invention ;
les figures 6 et 7 illustrent la détermination de plages de valeurs de champs magnétiques d'écriture selon le premier exemple de réalisation du procédé d'écriture de l'invention ;
les figures 8A à 8C représentent les évolutions des composantes des vecteurs moments magnétiques de la région magnétique libre de l'élément mémoire selon l'invention pour différents champs magnétiques d'écriture selon le premier exemple de réalisation du procédé d'écriture ;
les figures 9 et 10 représentent des plages de valeurs de champs magnétiques d'écriture selon le premier exemple de réalisation du procédé d'écriture selon l'invention pour un élément mémoire quasiment compensé selon l'invention ; et
les figures 11A à 11C, 12A à 12C, 13, 14A, 14B, 15A et 15B décrivent schématiquement l'évolution de l'orientation de vecteurs moment magnétique de la région magnétique libre lors de l'écriture d'un élément mémoire compensé ou quasiment compensé selon l'invention pour différents champs magnétiques d'écriture selon un second exemple de procédé d'écriture.

La demanderesse a mis en évidence, par de nombreux essais et simulations, qu'en prévoyant une dissymétrie de certaines propriétés magnétiques des couches ferromagnétiques constituant la région magnétique libre de l'élément mémoire, il est possible d'effectuer une écriture directe de l'élément mémoire, même avec une structure compensée, en utilisant des champs magnétiques d'écriture d'amplitudes modérées.

Selon un premier exemple de réalisation du procédé d'écriture selon l'invention qui sera décrit plus en détail par la suite, on cherche à obtenir une région magnétique libre compensée ou quasiment compensée pour laquelle l'une des propriétés suivantes ou les deux propriétés suivantes sont différentes :

- les champs d'anisotropie d'origine cristallographique ;
- les tenseurs de champ démagnétisant.

Par tenseurs de champ démagnétisant, on entend le tenseur dont le produit matriciel avec les cosinus directeurs de l'aimantation de la couche ferromagnétique donne le champ démagnétisant dans cette couche.

En effet, ce sont principalement ces grandeurs qui interviennent dans les phénomènes mis en oeuvre dans le premier exemple de réalisation du procédé d'écriture selon l'invention.

La différenciation des composantes selon la direction d'empilement des tenseurs de champ démagnétisant des couches ferromagnétiques est obtenue en prévoyant des couches ferromagnétiques ayant des géométries différentes, notamment des épaisseurs différentes.

La différenciation des champs d'anisotropie d'origine cristallographique est obtenue par l'une des possibilités suivantes ou par une combinaison des possibilités suivantes :

- en prévoyant des couches ferromagnétiques composées de matériaux différents ;
- en prévoyant des couches ayant subi des traitements différents pour stabiliser des structures cristallographiques différentes, notamment par des conditions de dépôt, des recuits sous champ magnétique ou des implantations d'ions.

La présente invention s'applique à un élément mémoire 16, du type représenté en figure 2, dont la région magnétique libre 18 comprend deux couches ferromagnétiques 26, 28 couplées antiferromagnétiquement qui ont respectivement des épaisseurs $e_1$ et $e_2$. On peut obtenir des épaisseurs $e_1$ et $e_2$ différentes, tout en maintenant la compensation de la région magnétique libre 18, notamment par l'une des possibilités suivantes ou par une combinaison des possibilités suivantes :

- les couches ferromagnétiques 26, 28 sont constituées de deux matériaux ferromagnétiques différents ayant des aimantations à saturation différentes ;

- les couches ferromagnétiques 26, 28 ont des sections droites différentes dans un plan perpendiculaire à la direction de l'empilement.

La présente invention s'applique également à un élément mémoire dont la région magnétique libre comprend un empilement de plusieurs régions magnétiques libres compensées ou quasiment compensées comme cela est représenté en figure 3.

Dans cet empilement, les conditions suivantes doivent être respectées :

- l'empilement démarre au contact de la couche barrière 20 par une première région magnétique libre compensée ou quasiment compensée 18 ;
- au dessus d'une première couche de séparation 36 recouvrant la première région magnétique libre 18, on prévoit une deuxième région magnétique libre 18' qui doit être la symétrique de la première région magnétique libre 18 par rapport au plan médian de la couche de séparation 36 ;
- au dessus d'une deuxième couche de séparation 36' recouvrant la deuxième région magnétique libre 18', on prévoit une troisième région magnétique libre 18" qui doit être la symétrique de la deuxième région magnétique libre 18' par rapport au plan médian de la deuxième couche de séparation 36', c'est-à-dire que l'on retrouve ici la région magnétique libre 18 ;
- et ainsi de suite selon le besoin, de façon que ce soit toujours le même type de couche ferromagnétique (26 ou 28) qui se trouve de part et d'autre d'une couche de séparation 36, 36', etc ;
- les couches de séparation 36, 36', etc, induisent un couplage ferromagnétique fort entre les couches ferromagnétiques qu'elles séparent, gardant ainsi parallèles leurs vecteurs moment magnétique.

Avec les conditions d'empilement énoncées ci-dessus, chacun des vecteurs moment magnétique $\vec{\mu}_1$ (respectivement $\vec{\mu}_2$) de chaque région magnétique libre 18, 18', 18", etc. va montrer le même comportement sous l'effet des séquences de champs magnétiques d'écriture de la présente invention, et ce comportement sera identique à celui qu'aurait montré le vecteur $\vec{\mu}_1$ (respectivement $\vec{\mu}_2$) d'une région magnétique libre unique telle que présentée sur la figure 2. Ainsi, lors de la phase d'écriture, le couplage ferromagnétique induit par les couches de séparation 36, 36', etc. n'influence que marginalement les processus, et les paramètres d'écriture seront les mêmes pour une région ferromagnétique libre (figure 2) et un empilement de régions ferromagnétiques libres (figure 3) de mêmes couches 24, 26 et 28. Par contre, lors de la phase de rétention de l'information, les couplages ferromagnétiques induits par les couches de séparation 36, 36', etc. rassemblent en un seul volume magnétique toutes les régions magnétiques libres de l'empilement, augmentant par un facteur au mieux égal au nombre de régions empilées le volume magnétique qui intervient dans la stabilité thermique de l'enregistrement. Ainsi, en augmentant le nombre de régions magnétiques empilées, il devient possible d'optimiser le fonctionnement de l'élément mémoire par l'une des actions suivantes ou par une combinaison des actions suivantes :

- réduire l'anisotropie effective globale de chaque région magnétique libre 18, 18', 18" etc., ce qui permet de réduire l'amplitude des champs magnétiques d'écriture,
- réduire les dimensions latérales d'un élément de mémoire vive magnétique sans avoir à augmenter son anisotropie magnétique totale.

Ces points sont très avantageux dans une optique d'augmentation de la densité des mémoires MRAM.

De plus, chaque région magnétique libre étant compensée ou quasi compensée, l'augmentation du nombre de régions dans l'empilement se fait sans augmentation notable du moment magnétique total, donc sans générer d'effets négatifs liés aux interactions dipolaires entre cellules.

Ce modèle d'empilement parfaitement périodique est décrit ci-dessus pour le cas où les champs d'écriture sont uniformes sur l'épaisseur totale de l'empilement. Une déviation modérée par rapport à cette contrainte peut être aisément compensée par un ajustement des paramètres de chaque région magnétique libre de l'empilement.

Un cas limite d'empilement du type représenté en figure 3 comporte seulement deux régions magnétiques libres 18, 18', entre lesquelles la couche de séparation 36 a été ramenée à une épaisseur nulle. La région magnétique libre comprend alors un empilement de trois couches ferromagnétiques : une couche ferromagnétique inférieure, une couche ferromagnétique intermédiaire et une couche ferromagnétique supérieure.

Selon un deuxième exemple de réalisation du procédé d'écriture selon l'invention, qui sera décrit plus en détail par la suite, on cherche à obtenir une région magnétique libre compensée ou quasiment compensée pour laquelle les champs d'anisotropie effectifs planaires des couches ferromagnétiques sont différents. Le champ d'anisotropie effectif planaire d'une couche ferromagnétique est le champ d'anisotropie global qui caractérise l'anisotropie de l'énergie magnétique de la couche ferromagnétique lorsque son aimantation tourne dans le plan perpendiculaire à la direction d'empilement. Ce champ d'anisotropie effectif intègre le champ d'anisotropie d'origine cristallographique et l'anisotropie de forme due à l'anisotropie du tenseur de champ démagnétisant.

La différence des champs d'anisotropie effectifs planaires des couches ferromagnétiques peut donc être obtenue par l'une des possibilités suivantes ou par une combinaison des possibilités suivantes :

- les couches ferromagnétiques 26, 28 sont constituées de deux matériaux ferromagnétiques différents ayant des aimantations à saturation différentes ;
- les couches ferromagnétiques 26, 28 ont des anisotropies de forme différentes, ce qui peut s'obtenir par une différence de section droite des couches dans un plan perpendiculaire à la direction d'empilement, ou par des épaisseurs différentes ;
- les couches ferromagnétiques 26, 28 ont des anisotropies magnétiques de nature cristallographique différente.

La présente invention s'applique également à un empilement de régions ferromagnétiques libres compensées ou quasi compensées, tel que présenté sur la figure 3, avec les mêmes conditions sur la réalisation de l'empilement que celles décrites ci-dessus pour le premier exemple de l'invention, et en produisant les mêmes avantages.

Selon le premier et le deuxième exemples de réalisation du procédé d'écriture selon l'invention, la demanderesse a mis en évidence qu'au moment de l'application de champs magnétiques d'écriture adaptés, des vecteurs moment magnétique $\vec{\mu}_1$ et $\vec{\mu}_2$ de sens opposé d'au moins deux couches ferromagnétiques se déplacent avec des trajectoires différentes, mais corrélées à travers l'interaction antiferromagnétique qui les lie. Ceci permet, avec des champs magnétiques d'écriture adaptés, d'orienter avec certitude le vecteur moment magnétique de la couche ferromagnétique la plus proche de la couche barrière selon un sens et une orientation privilégiés, tout en minimisant la valeur maximale atteinte par le moment magnétique total $\vec{\mu}_{tot}$ de la région magnétique libre pendant le processus d'écriture.

Deux exemples de réalisation du procédé d'écriture selon l'invention vont maintenant être décrits. A des fins de clarté, on considérera sans perte de généralité un élément mémoire 16 dont la région magnétique libre 18 comporte deux couches ferromagnétiques 26, 28, comme cela est représenté en figure 2. La couche ferromagnétique 26 est composée d'un premier matériau ferromagnétique, par exemple un alliage de cobalt et de fer, et a une épaisseur $e_1$ et une aimantation à saturation $M_{S1}$. La couche ferromagnétique 28 est constituée d'un second matériau ferromagnétique, différent du premier matériau ferromagnétique, par exemple un alliage de nickel et de fer, et a une épaisseur $e_2$ et une aimantation à saturation $M_{S2}$. La couche de couplage 24 est par exemple une couche de ruthénium dont l'épaisseur est adaptée pour obtenir une énergie de couplage d'interface antiferromagnétique ayant une intensité J par unité de surface.

La figure 4 représente schématiquement l'élément mémoire 16 selon l'invention, vu de dessus, pris en sandwich entre une ligne de mot 12 et une ligne de bit 14. On suppose que les trois couches 24, 26, 28 ont une même section dans la direction de l'empilement, qui est supposée pour simplifier être circulaire et de rayon R. A titre d'exemple, R est d'environ 45 nanomètres.

La compensation des vecteurs moment magnétique $\vec{\mu}_1$ et $\vec{\mu}_2$ est donc obtenue par l'égalité suivante :

$$M_{S1}e_1 = M_{S2}e_2$$

Avec les matériaux indiqués à titre d'exemple, la compensation peut être obtenue pour $e_1$ égal à environ 5 nanomètres et $e_2$ égal à environ 10 nanomètres

On note $K_1$ et $K_2$ les constantes effectives d'anisotropie planaire respectivement des couches ferromagnétiques 26, 28. Etant donné que, dans le présent exemple, chaque région magnétique 26, 28 est circulaire, les constantes d'anisotropie $K_1$, $K_2$ reflètent essentiellement les anisotropies d'origine cristallographique des couches ferromagnétiques 26, 28. Les constantes d'anisotropie des couches ferromagnétiques 26, 28 sont choisies de façon à garantir la non volatilité de l'élément mémoire 16, par exemple jusqu'à une durée de 10 ans pour une température de fonctionnement de l'ordre de 120°C. Les champs d'anisotropie effectifs planaires $H_{A1}$ et $H_{A2}$, respectivement associés aux couches ferromagnétiques 26, 28, sont donnés par les expressions suivantes :

$$H_{A1}=2K_1/(\mu_0M_{S1})$$

$$H_{A2}=2K_2/(\mu_0M_{S2})$$

où $\mu_0$ est la perméabilité du vide. Dans le présent exemple, le produit $u_0M_{S1}$ est égal à environ 2,2 Tesla et le produit $\mu_0M_{S2}$ est égal à environ 1,1 Tesla. Les champs d'échange $H_{J1}$, $H_{J2}$ issus de l'interaction d'échange antiferromagnétique et respectivement associés aux couches ferromagnétiques 26, 28 sont donnés par les expressions suivantes :

$$H_{J1}=J/\mu_0e_1M_{S1}$$

$$H_{J2}=J/\mu_0e_2M_{S2}$$

On définit un repère orthonormé (OX, OY, OZ) dans lequel l'axe (OX) s'étend sensiblement selon la direction longitudinale de la ligne de mot 12, l'axe (OY) s'étend sensiblement selon la direction longitudinale de la ligne de bit 14 et l'axe (OZ) (non représenté) est perpendiculaire au plan (XOY) et s'étend selon la direction d'empilement de l'élément mémoire 16. On suppose que les couches ferromagnétiques 26, 28 ont une direction de facile aimantation selon la direction (OX).

Pour simplifier, nous supposons aussi que l'énergie d'anisotropie effective selon la direction d'empilement ne dépend que de l'anisotropie de forme liée au tenseur de champ démagnétisant. Les composantes suivant l'axe (OZ) de ce tenseur respectivement associés aux couches 26, 28 sont notées $-N_{Z1}M_{S1}$ et $-N_{Z2}M_{S2}$, où $N_{Z1}$ et $N_{Z2}$ sont les facteurs démagnétisants selon l'axe (OZ).

Du fait de la symétrie des équations décrivant les énergies d'anisotropie d'origine cristallographique et de forme, le procédé de l'invention reste valide pour des cas où les anisotropies effectives planaires et selon la direction d'empilement mélangent des contributions d'origine cristallographique et de forme.

Lorsqu'un courant traverse la ligne de mot 12, il fournit un champ magnétique sensiblement circonférentiel autour de la ligne de mot 12, ce qui se traduit au niveau de l'élément mémoire 16 par un champ magnétique $H_Y$ selon la direction (OY). Lorsqu'un courant traverse la ligne de bit 14, il fournit un champ magnétique circonférentiel autour de la ligne de bit 14, ce qui se traduit au niveau de l'élément mémoire 16 par un champ magnétique $H_X$ selon la direction (OX). Le champ magnétique $H_X$ est positif s'il est orienté selon les X croissants et est négatif s'il est orienté selon les X décroissants. Le champ magnétique $H_Y$ est positif s'il est orienté selon les Y croissants et est négatif s'il est orienté selon les Y décroissants.

## 1) Premier exemple de réalisation du procédé d'écriture selon l'invention.

Le premier exemple de réalisation du procédé d'écriture d'un élément mémoire selon la présente invention est basé sur l'utilisation de la précession magnétique.

La figure 5 représente un exemple d'une séquence de champs magnétiques appliqués à l'élément mémoire 16 pour bénéficier de l'effet de précession magnétique. Lors d'une étape d'écriture, on applique un champ magnétique impulsionnel $H_X$ d'une durée $\Delta T$ égale à environ 400 picosecondes. Le signe du champ magnétique $H_X$ peut être positif ou négatif. Pendant la durée $\Delta T$, on applique un champ magnétique impulsionnel Hy positif ou négatif d'une durée $\Delta T'$ inférieure à environ 200 picosecondes. Pour permettre l'obtention du phénomène de précession, le temps de montée du champ magnétique impulsionnel $H_Y$ doit en théorie être très inférieur aux périodes de précession de $\vec{\mu}_1$ et $\vec{\mu}_2$. Expérimentalement, des temps de montée de l'ordre de 60 à 80 ps permettent de déclencher des précessions de période jusqu'à 6 GHz, correspondant aux paramètres des couches étudiées ici. L'impulsion de champ magnétique $H_Y$ peut être appliquée à n'importe quel moment au cours de l'impulsion de champ magnétique $H_X$, pourvu que $H_X$ seul ne soit pas suffisant pour modifier les orientations de $\vec{\mu}_1$ et $\vec{\mu}_2$. Dans le cas contraire, les impulsions de $H_X$ et $H_Y$ doivent être simultanées dans la limite d'un décalage temporel du même ordre de grandeur que le temps de montée du champ magnétique défini précédemment.

Une description possible du phénomène de précession magnétique recherché dans le procédé de l'invention au niveau d'une structure compensée ou quasiment compensée à deux couches ferromagnétiques 26, 28 est la suivante. L'impulsion de champ magnétique $H_Y$ conduit chaque vecteur moment magnétique $\vec{\mu}_1$, $\vec{\mu}_2$ à sortir du plan (XOY) par précession autour de l'axe (OY), avec initialement la même vitesse angulaire. L'apparition d'une composante de $\vec{\mu}_1$ et $\vec{\mu}_2$ selon l'axe (OZ) donne immédiatement naissance à des champs démagnétisants selon (OZ), de sens opposés pour les couches 26, 28. Ces champs démagnétisants cherchent à faire tourner $\vec{\mu}_1$ et $\vec{\mu}_2$ l'un vers l'autre par précession autour de (OZ), ce qui viole le principe de minimisation de l'énergie d'interaction antiferromagnétique à travers la couche 24. Sous l'effet de toutes les sources d'énergie magnétique du système (énergie d'interaction antiferromagnétique, champs $H_X$, $H_Y$, champs démagnétisants et énergie d'anisotropie d'origine cristallographique), l'un des vecteurs $\vec{\mu}_1$ ou $\vec{\mu}_2$ (noté pour la suite "vecteur maître") va continuer sa précession autour de (OZ), entraînant l'autre vecteur (noté par la suite "vecteur esclave") qui va donc rebrousser chemin et entamer une rotation de même sens conservant au maximum l'alignement antiparallèle entre $\vec{\mu}_1$ et $\vec{\mu}_2$, ce qui minimise la valeur maximale atteinte par le vecteur moment magnétique total $\vec{\mu}_{tot}$ pendant le processus. Selon les paramètres exacts de l'expérience, des précessions supplémentaires de faible amplitude peuvent se superposer au comportement moyen décrit ci-dessus sans remettre en cause son principe.

Ce phénomène de renversement simultané de $\vec{\mu}_1$ et $\vec{\mu}_2$ minimisant $\vec{\mu}_{tot}$ peut s'obtenir pour des couches 26, 28 identiques, mais il ne permet alors qu'un mode d'écriture par basculement (toggle). C'est la différentiation des propriétés magnétiques des couches 26, 28 qui permet d'obtenir un mode d'écriture directe. Dans ce dernier, pour des couples de valeurs adaptées des champs magnétiques $H_X$ et $H_Y$, on peut assurer qu'en fonction de leurs positions initiales, $\vec{\mu}_1$ et $\vec{\mu}_2$ conservent leurs positions initiales ou effectuent un mouvement de précession autour du champ magnétique démagnétisant associé jusqu'à parvenir à des positions opposées aux positions initiales. Pour des couples de champs magnétiques $H_X$ et $H_Y$ adaptés, on peut donc assurer que la position finale du vecteur moment magnétique le plus proche de la couche barrière 20 est selon une orientation et un sens souhaités.

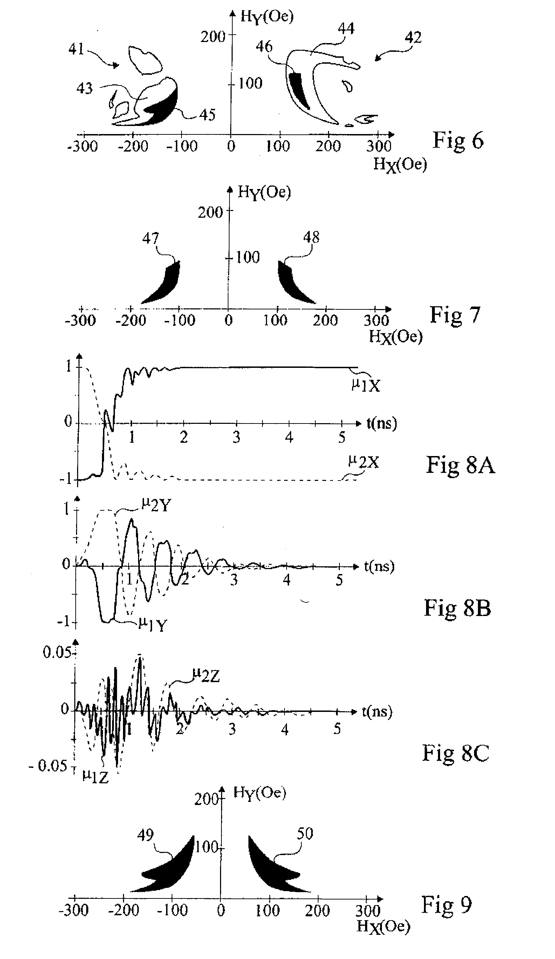

A titre d'exemple, la figure 6 représente un ensemble non complet de zones 41, 42 d'amplitudes de champs magnétiques $H_X$ et $H_Y$, le champ magnétique $H_Y$ étant positif, pour lesquelles on obtient systématiquement un basculement de $\vec{\mu}_1$, orienté initialement le long de l'axe (OX) selon les X décroissants. Cette figure a été déterminée avec les valeurs suivantes des propriétés magnétiques des couches : $e_1$=5 nm, $M_{S1}$=2,2 Tesla, $e_2$=10 nm, $M_{S2}$=1,1 Tesla, $H_{A1}$=5,41 kA/m (=68 Oe), $H_{A2}$=1,11 kA/m (=14 Oe), $\Delta T = \Delta T'$=200 ps, $H_{J1}$=$H_{J2}$=15.9 kA/m (=200 Oe). Pour un champ magnétique $H_Y$ négatif, les zones obtenues sont symétriques par rapport à l'axe des abscisses. On obtient à la fois des zones 41 correspondant à des champs magnétiques $H_X$ négatifs et des zones 42 correspondant à des champs magnétiques $H_X$ positifs pour lesquelles un basculement de $\vec{\mu}_1$ est observé.

Les zones 41, 42 comprennent des portions "blanches" 43, 44 délimitées par les courbes en traits pleins qui correspondent à des champs magnétiques $H_X$ et $H_Y$ pour lesquels la norme de $\vec{\mu}_{tot}$, notée par la suite $\mu_{tot}$, excède la norme du vecteur moment magnétique $\vec{\mu}_1$, notée par la suite $\mu_1$, au moins à un moment au cours du basculement de $\vec{\mu}_1$. Les zones 41, 42 comprennent des portions noires 45, 46 qui correspondent à des champs magnétiques $H_X$ et $H_Y$ pour lesquels $\mu_{tot}$ n'excède jamais $\mu_1$ au cours du basculement de $\vec{\mu}_1$.

Pour minimiser les interactions entre l'élément mémoire 16 et les éléments mémoire adjacents, il est donc préférable de se limiter à des champs magnétiques $H_X$ et $H_Y$ associés aux portions noires 45, 46. Il faut en outre se limiter à des champs magnétiques $H_X$ et $H_Y$ pour lesquels, quelle que soit l'orientation initiale de $\vec{\mu}_1$, on parvient toujours à la même orientation finale. Ceci est obtenu en tenant compte du fait que les zones 41 et 42 ne sont pas symétriques par rapport à l'axe des ordonnées en raison de la dissymétrie des propriétés magnétiques des couches ferromagnétiques 26, 28.

La figure 7 représente des zones d'écriture 47, 48, obtenues à partir des zones 41, 42 de la figure 5, et correspondant à des valeurs des champs magnétiques $H_X$, $H_Y$ qui imposent une orientation finale déterminée de $\vec{\mu}_1$ quelle qu'en soit l'orientation initiale. Ceci est obtenu en superposant les zones 41 et 42 de la figure 6 à des zones correspondant aux symétriques des zones 41, 42 par rapport à l'axe des ordonnées et en ne retenant que les zones qui ne sont pas communes et pour lesquelles $\mu_{tot}$ n'excède jamais $\mu_1$. Les champs magnétiques $H_X$ et $H_Y$ associés à la zone d'écriture 47 permettent d'assurer que $\vec{\mu}_1$ est finalement orienté selon les X croissants et les champs magnétiques $H_X$ et $H_Y$ associés à la zone d'écriture 48 permettent d'assurer que $\vec{\mu}_1$ est finalement orienté selon les X décroissants.

Les figures 8A à 8C représentent respectivement une simulation de l'évolution des composantes $\mu_{1X}$, $\mu_{1Y}$, $\mu_{1Z}$ (courbes en traits pleins) de $\vec{\mu}_1$ dans le repère (OX, OY, OZ) et des composantes $\mu_{2X}$, $\mu_{2Y}$, $\mu_{2Z}$ (courbes en traits pointillés) de $\vec{\mu}_2$ pour un champ magnétique $H_X$ négatif dont l'amplitude est égale à 9710 A/m (=122 Oe) et un champ magnétique $H_Y$ positif dont l'amplitude est égale à 1590 A/m (=20 Oe). La simulation utilise les mêmes paramètres que ceux utilisés pour calculer les figures 6 et 7. Les composantes sont normées à $\mu_1$, qui est identique à $\mu_2$, norme de $\vec{\mu}_2$, pour un

élément mémoire compensé.

Comme cela apparaît aux figures 8A à 8C, $\vec{\mu}_1$ et $\vec{\mu}_2$ sont initialement orientés selon l'axe (OX) respectivement dans le sens des X décroissants et croissants. Le temps initial t=0 correspond à l'établissement du champ magnétique $H_Y$. On observe que $\vec{\mu}_1$ bascule en moins de 1 nanoseconde après application de l'impulsion de champ magnétique $H_Y$ pour s'orienter selon l'axe (OX) selon le sens des X croissants. Après basculement, on observe des oscillations de moindres amplitudes pendant quelques nanosecondes. Toutefois, il apparaît que les oscillations sont très largement amorties après 3 nanosecondes. A 5 nanosecondes, l'état de l'élément mémoire 16 est complètement stabilisé. Le premier exemple de réalisation du procédé d'écriture selon l'invention permet donc d'atteindre une période d'écriture d'environ 3 nanosecondes avec les paramètres utilisés ici pour le calcul, hors de toute optimisation.

En outre, $\mu_{tot}$ reste très faible tout au long du basculement de $\vec{\mu}_1$ et, en particulier, n'excède à aucun moment $\mu_1$. plus, $\mu_{tot}$ prend sa valeur maximale seulement sur une très faible durée au cours du basculement de $\vec{\mu}_1$. La participation de $\vec{\mu}_{tot}$ aux perturbations des éléments mémoire adjacents à l'élément mémoire adressé à cause des interactions dipolaires est donc très faible. En outre, la faible durée et les faibles amplitudes des champs magnétiques $H_X$ et $H_Y$ permettent de minimiser l'énergie nécessaire à l'écriture.

Par de nombreuses simulations sur une large gamme de paramètres magnétiques, et une étude détaillée des comportements obtenus, la demanderesse a par ailleurs établi que le processus d'écriture directe selon ce premier exemple de l'invention est plus favorable lorsque c'est la couche ferromagnétique de plus forte aimantation à saturation qui possède aussi la plus forte anisotropie effective planaire.

Plus généralement, dans la conception de la région magnétique libre d'un élément mémoire compensé ou quasi compensé, il s'agit d'assurer la conjonction de la dissymétrie des champs d'anisotropie d'origine cristallographique et des champs démagnétisants afin d'augmenter la dissymétrie des zones 41, 42 et de réduire l'amplitude des champs $H_X$, $H_Y$ nécessaires au processus d'écriture.

La figure 9 représente des zones d'écriture 49, 50 analogues aux zones d'écriture 47, 48 de la figure 7 et calculée avec les mêmes paramètres magnétiques sauf $e_2$=12 nm, ce qui donne $\mu_2$=1,2$\mu_1$. L'élément mémoire 16 n'est alors plus à structure compensée mais à structure quasiment compensée. On observe une augmentation de la surface des zones d'écriture 49, 50 par rapport à la figure 7. En particulier, l'écriture de l'élément mémoire peut être réalisée avec des champs magnétiques $H_X$ et $H_Y$ dont les amplitudes sont inférieures aux amplitudes respectives des champs magnétiques requis pour l'écriture d'un élément mémoire compensé.

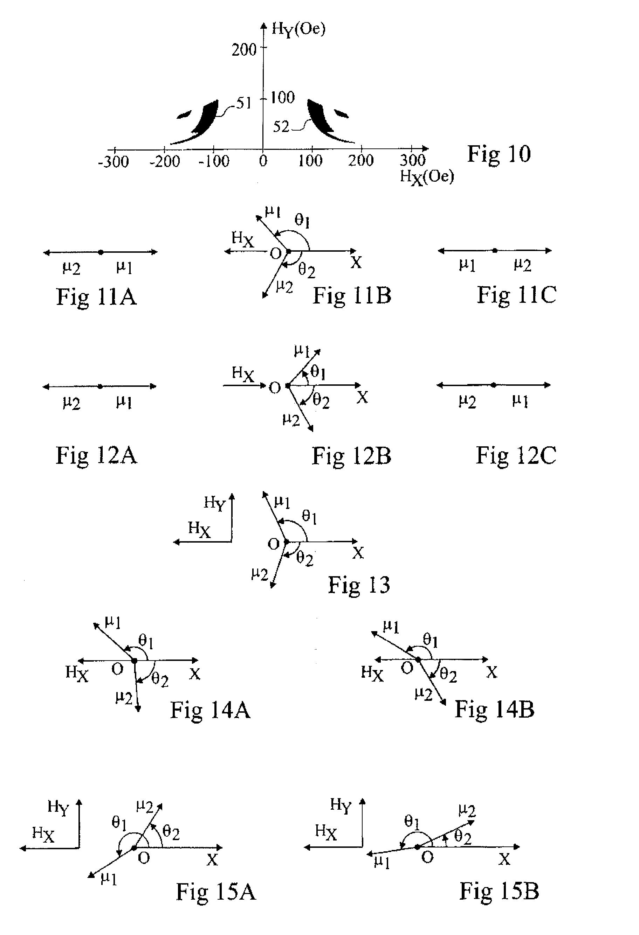

La figure 10 représente des zones d'écriture 51, 52 analogues aux zones d'écriture 47, 48 de la figure 7 et calculées avec les mêmes paramètres magnétiques sauf $e_1$=6 nm, ce qui donne $\mu_1$=1, $2\mu_2$. On observe une diminution de la surface des zones d'écriture 51, 52 par rapport à la figure 7. Une telle modification de la compensation de l'élément mémoire n'est donc pas souhaitable.

L'origine physique des différences entre les figures 9 et 10 vient du fait que, avec les valeurs de champs magnétiques $H_X$ et $H_Y$ correspondant aux zones d'écriture 47, 48 de la figure 7, c'est $\vec{\mu}_2$ qui est le vecteur maître et $\vec{\mu}_1$ le vecteur esclave dans le processus d'écriture. En analysant en détail les diverses énergies magnétiques et actions correspondantes, on vérifie qu'une légère décompensation de la région magnétique libre qui renforce la norme du vecteur maître (respectivement esclave) est favorable au processus d'écriture (respectivement défavorable), en ce sens qu'elle diminue (respectivement augmente) les champs $H_X$ et $H_Y$ nécessaires à l'écriture, et augmente (respectivement diminue) l'extension de la zone de champs $H_X$ et $H_Y$ permettant l'écriture directe.

De façon plus générale, pour une région magnétique libre 18 ayant deux ou plus de deux couches ferromagnétiques, on obtient des plages d'écriture plus favorables en choisissant une structure quasiment compensée plutôt que compensée, réalisée en empilant comme sur la figure 3 des régions magnétiques libres 18, 18', 18" quasi compensées où l'on a renforcé la norme du vecteur moment magnétique agissant comme vecteur maître lors du processus d'écriture.

La demanderesse a mis en évidence la présence d'une plage de champs magnétiques d'écriture d'amplitudes relativement modérées permettant l'écriture d'un élément mémoire compensé, et a décrit la méthode pour optimiser la localisation et l'étendue de cette plage en jouant sur la dissymétrie des propriétés magnétiques de la région magnétique libre de l'élément mémoire. En outre, la demanderesse a mis en évidence que l'on peut diminuer l'amplitude des champs magnétiques utilisables pour l'écriture d'un élément mémoire en choisissant une structure quasiment compensée particulière.

## 2) Deuxième exemple de réalisation du procédé d'écriture selon l'invention.

Le deuxième exemple de réalisation du procédé d'écriture d'un élément mémoire selon la présente invention est basé sur l'utilisation de la différence de réaction des vecteurs moments magnétiques $\vec{\mu}_1$ et $\vec{\mu}_2$ lors de l'application d'un champ magnétique (de temps de montée lent par rapport à l'établissement d'un mode précessionnel), lorsqu'il existe une différence des champs d'anisotropie effective planaire des couches ferromagnétiques de la région magnétique libre de l'élément mémoire. Pour un élément mémoire 16 ayant une région magnétique libre 18 compensée ou quasi compensée à deux couches ferromagnétiques, le champ d'anisotropie $H_{A1}$ de la couche ferromagnétique 26 adjacente à la couche barrière 20 est plus important que le champ d'anisotropie $H_{A2}$ de l'autre couche ferromagnétique 28. Pour un élément mémoire 16 ayant une région magnétique libre comprenant au moins trois couches ferromagnétiques, et réalisée par un empilement de régions magnétiques libres compensées ou quasi compensées au sens de la figure 3, le champ d'anisotropie d'une couche ferromagnétique dont le vecteur moment magnétique associé est orienté comme le vecteur moment magnétique associé à la couche ferromagnétique adjacente à la couche barrière est plus important que le champ d'anisotropie de n'importe quelle couche ferromagnétique dont le vecteur moment magnétique est orienté dans le sens opposé à celui du vecteur moment magnétique associé à la couche ferromagnétique adjacente à la couche barrière.

Les figures 11A à 11C illustrent des étapes successives de l'écriture d'un élément mémoire 16 selon l'invention par le deuxième exemple de réalisation du procédé d'écriture consistant à appliquer un champ magnétique $H_X$ seul, le champ magnétique $H_Y$ étant maintenu à zéro.

La figure 11A représente schématiquement l'orientation de $\vec{\mu}_1$ et $\vec{\mu}_2$ avant l'application du champ magnétique $H_X$. $\vec{\mu}_1$ est initialement orienté le long de l'axe (OX) selon les X croissants et $\vec{\mu}_2$ est initialement orienté le long de l'axe (OX) selon les X décroissants. On utilise pour l'exemple les mêmes valeurs de propriétés magnétiques des couches que pour les figures 6 et 7, soit: $e_1$=5 nm, $M_{S1}$=2,2 Tesla, $e_2$=10 nm, $M_{S2}$=1,1 Tesla, $H_{A1}$=5,41 kA/m (=68 Oe), HA2=1,11 kA/m (=14 Oe), $H_{J1}$=$H_{J2}$=15.9 kA/m (=200 Oe). Le calcul étant fait pour une température nulle, les durées d'application $\Delta T$ et $\Delta T'$ n'ont pas de signification dans ce calcul. Dans un processus expérimental réel, il suffit que ces durées soient supérieures aux temps de relaxation des vecteurs moment magnétique $\vec{\mu}_1$ et $\vec{\mu}_2$ vers leurs positions d'équilibre. La demanderesse a mis en évidence que pour un champ magnétique $H_X$ négatif dont la valeur absolue est inférieure à 11937 A/m (=150 Oe), l'orientation de $\vec{\mu}_1$ ne change pas de manière notable, et tout changement reste réversible. Pour un champ magnétique $H_X$ négatif dont la valeur absolue est supérieure à 11937 A/m (=150 Oe), on observe un basculement irréversible aussi appelé "spin-flop".

La figure 11B représente un exemple de configuration obtenue pour l'application d'un champ magnétique $H_X$ négatif dont la valeur absolue est égale à 14334 A/m (=180 Oe). On définit $\theta_1$ l'angle formé par $\mu_1$ et l'axe (OX) et $\theta_2$ l'angle formé par $\mu_2$ et l'axe (OX). Selon le présent exemple, $\theta_1$ est égal à environ +132° et $\theta_2$ est égal à environ -119°, mais l'état [$\theta_1$=-132° et $\theta_2$=+119°] est aussi possible avec la même énergie magnétique et donc la même probabilité. Lorsque le champ magnétique $H_X$ est remis à zéro, sous l'effet de sa plus grande énergie d'anisotropie effective planaire $\vec{\mu}_1$ rejoint l'axe (OX) selon les X décroissants et $\vec{\mu}_2$ bascule

pour s'aligner le long de l'axe (OX) selon les X croissants sous l'effet de l'interaction antiferromagnétique.

La figure 11C représente schématiquement l'orientation de $\vec{\mu}_1$ et $\vec{\mu}_2$ après basculement. $\vec{\mu}_1$ est orienté le long de l'axe (OX) selon les X décroissants et $\vec{\mu}_2$ est orienté le long de l'axe (OX) selon les X croissants.

Les figures 12A à 12C décrivent des figures similaires aux figures 11A à 11C lorsqu'un champ magnétique $H_X$ positif est appliqué à l'élément mémoire 16.

La figure 12A est identique à la figure 11A. En figure 12B, on obtient, pour un champ magnétique $H_X$ positif dont la valeur absolue est d'environ 14334 A/m (=180 Oe), un angle $\theta_1$ d'environ +48° et un angle $\theta_2$ d'environ -61°, mais l'état [$\theta_1$=-48° et $\theta_2$=+61°] est aussi possible avec la même énergie magnétique et donc la même probabilité. Lorsque le champ magnétique $H_X$ est remis à zéro, sous l'effet de sa plus grande énergie d'anisotropie effective planaire, $\vec{\mu}_1$ se réaligne le long de l'axe (OX) selon les X croissants. $\vec{\mu}_2$ est alors renvoyé le long de l'axe (OX) selon les X décroissants sous l'effet de l'interaction antiferromagnétique. On obtient alors la configuration représentée à la figure 12C, identique à la figure 12A.

On obtient donc un procédé d'écriture directe puisque l'on oriente $\vec{\mu}_1$ de façon déterminée, suivant le champ magnétique $H_X$ appliqué quelle que soit la configuration initiale. De plus, l'élément mémoire selon l'invention permet d'obtenir une écriture directe avec l'application d'un seul champ magnétique $H_X$.

La demanderesse a mis en évidence que lorsqu'on applique simultanément à $H_X$ un champ magnétique $H_Y$ positif dont la valeur absolue est d'environ 1591 A/m (=20 Oe), on obtient un basculement de $\vec{\mu}_1$ et $\vec{\mu}_2$ pour un champ magnétique $H_X$ négatif dont la valeur absolue est supérieure à environ 10345 A/m (=130 Oe), c'est-à-dire pour un champ magnétique $H_X$ dont la valeur absolue est inférieure à la valeur absolue du champ magnétique $H_X$ appliqué seul dans l'exemple décrit précédemment. Un champ magnétique $H_Y$ seul dont la valeur absolue est d'environ 1591 A/m (=20 Oe) ne suffit pas à faire basculer $\vec{\mu}_1$ et $\vec{\mu}_2$, et puisque la valeur absolue du champ magnétique $H_X$ de basculement est abaissée lorsque l'on applique simultanément des champs magnétiques $H_X$ et $H_Y$, il est possible d'utiliser un couple de champs magnétiques $H_X$ et $H_Y$ pour écrire directement une information dans un seul élément mémoire 16 sans changer l'état des éléments mémoire qui sont seulement adressés par l'un ou l'autre des champs magnétiques $H_X$ ou $H_Y$. Avec les paramètres de la région magnétique libre retenus pour le calcul, une augmentation de la valeur absolue du champ magnétique $H_Y$ au-delà de environ 2000 A/m (quelques dizaines d'Oe) est défavorable pour obtenir le basculement de $\vec{\mu}_1$ et $\vec{\mu}_2$, puisqu'il est alors nécessaire d'appliquer un champ magnétique $H_X$ ayant une amplitude plus élevée pour obtenir le basculement.

La figure 13 représente, à titre d'exemple, les positions de $\vec{\mu}_1$ et $\vec{\mu}_2$, de façon analogue à la figure 11B et en partant de la configuration de la figure 11A, dans le cas où sont appliqués un champ magnétique $H_X$ négatif et un champ magnétique $H_Y$ positif. A titre d'exemple, pour un champ magnétique $H_X$ négatif dont la valeur absolue est d'environ 11141 A/m (=140 Oe), on obtient $\theta_1$ égal à environ 115° et $\theta_2$ égal à environ -108°.

Les figures 14A et 14B représentent chacune l'orientation de $\vec{\mu}_1$ et $\vec{\mu}_2$, de façon analogue à la figure 11B et en partant de la configuration de la figure 11A, dans le cas où seul un champ magnétique $H_X$ négatif est appliqué et dans le cas où la région magnétique libre 18 comporte une légère dissymétrie de la compensation des vecteurs moment magnétique.

En figure 14A, on a $\mu_1$=1, 1$\mu_2$ en prenant $e_1$=5, 5 nm. Un basculement est obtenu pour un champ magnétique $H_X$ négatif dont la valeur absolue est supérieure à environ 11937 A/m (=150 Oe). Par exemple, pour un champ magnétique $H_X$=-11937 A/m (=-150 Oe), $\theta_1$ est alors égal à environ 138° et $\theta_2$ est égal à environ -85°, ce qui correspond à $\mu_{tot}$ = 0,77$\mu_2$.

En figure 14B, on a $\mu_1$=1, 2 $\mu_2$ obtenu en prenant $e_1$=6 nm. Un basculement est obtenu pour un champ magnétique $H_X$ négatif dont l'amplitude est supérieure à environ 10345 A/m (=130 Oe). Pour un champ magnétique $H_X$ négatif dont la valeur absolue est égale à 10345 A/m (=130 Oe), $\theta_1$ est alors égal à environ 149° et $\theta_2$ est égal à environ -59°, ce qui correspond à $\mu_{tot}$ = 0, 57 $\mu_2$.

Lorsque $\mu_1$ est inférieur à $\mu_2$, il est nécessaire d'utiliser des champs magnétiques d'amplitudes plus élevées pour obtenir le basculement de $\vec{\mu}_1$ et $\vec{\mu}_2$, ce qui n'est pas souhaitable.

Les figures 15A et 15B représentent chacune l'orientation de $\vec{\mu}_1$ et $\vec{\mu}_2$, de façon analogue à la figure 13, dans le cas où un champ magnétique $H_X$ négatif et un champ magnétique $H_Y$ positif sont appliqués simultanément et dans le cas où la région magnétique libre 18 de l'élément mémoire 16 comporte une légère dissymétrie de la compensation des vecteurs moment magnétique.

En figure 15A, on a $\mu_1$=1,1$\mu_2$ obtenu en prenant $e_1$=5, 5 nm. Pour un champ magnétique $H_Y$ positif dont la valeur absolue est de l'ordre de 2387 A/m (=30 Oe), on observe un basculement pour un champ magnétique $H_X$ négatif dont la valeur absolue est supérieure à environ 9151 A/m (=115 Oe). A titre d'exemple, pour un champ magnétique $H_X$ négatif dont la valeur absolue est égale à 10345 A/m (=130 Oe), $\theta_1$ est égal à environ 212° et $\theta_2$ est égal à environ 57°. $\vec{\mu}_2$ a alors tourné d'un angle supérieur à 180°. Pendant le retournement, $\mu_{tot}$ est égal à environ 0, 46$\mu_2$. Un tel élément mémoire est particulièrement avantageux dans la mesure où lorsque le champ magnétique $H_Y$ est nul, l'amplitude minimale du champ magnétique $H_X$ d'écriture est supérieure à 150 Oe. En outre, $\mu_{tot}$ reste relativement faible. On a alors un écart important d'amplitude minimale de champ magnétique $H_X$ d'écriture, tout en conservant des amplitudes relativement modérées. Ceci est favorable notamment pour éviter une écriture indésirable d'éléments mémoire autres que l'élément mémoire adressé.

En figure 15B, on a $\mu_1=1$, $2\mu_2$ obtenu en prenant $e_1=6$ nm. Pour un champ magnétique $H_Y$ dont la valeur absolue est de l'ordre de 2387 A/m (=30 Oe), on observe un basculement pour un champ magnétique $H_X$ négatif dont la valeur absolue est supérieure à 8355 A/m (=105 Oe). A titre d'exemple, pour un champ magnétique $H_X$ négatif dont la valeur absolue est égale à 9549 A/m (=120 Oe), $\theta_1$ est égal à environ 188° et $\theta_2$ est égal à environ 25°. $\vec{\mu}_2$ a alors tourné d'un angle supérieur à 180°. $\mu_{tot}$ reste quasiment constant pendant le basculement et sensiblement égal à $0,46\mu_2$. Un tel cas est relativement moins avantageux que le précédent car l'écart entre les valeurs absolues minimales de champ magnétique $H_X$ d'écriture, pour un champ magnétique $H_Y$ d'amplitude nulle et d'amplitude égale à 8355 A/m (=30 Oe), est plus faible.

De façon générale, une décompensation de la région magnétique libre 18 de l'élément mémoire 16 consistant à augmenter la norme du vecteur moment magnétique associé au champ d'anisotropie effectif planaire le plus fort permet de diminuer l'amplitude minimale du champ magnétique $H_X$ à appliquer pour l'écriture de l'élément mémoire.

De façon plus générale, pour une région magnétique libre 18 ayant plus de deux couches ferromagnétiques, on obtient des amplitudes de champ d'écriture plus favorables en choisissant une structure quasiment compensée plutôt que compensée, réalisée en empilant comme sur la figure 3 des régions magnétiques libres de type 16 quasi compensées où pour chaque couche ferromagnétique on a renforcé la norme du vecteur moment magnétique associé au champ d'anisotropie effectif planaire le plus fort.

Dans la description ci-dessus du deuxième exemple de réalisation du procédé d'écriture selon l'invention, le choix d'une plus grande anisotropie effective planaire pour la couche 26 adjacente à la couche barrière 20 assure que le vecteur moment magnétique $\vec{\mu}_1$ de la couche 26 agit comme vecteur maître dans le processus d'écriture. Du fait de la symétrie des équations du magnétisme, le même procédé d'écriture directe (seul doit changer le signe de $H_X$) peut être réalisé en donnant une plus grande anisotropie effective planaire à la couche 28, le vecteur moment magnétique $\vec{\mu}_2$ de cette couche 28 agissant alors comme vecteur maître dans le processus d'écriture, et le couplage antiferromagnétique entre les couches 26 et 28 à travers la couche 24 garantissant l'alignement final du vecteur moment magnétique $\vec{\mu}_1$.

Il est enfin important de souligner que ce deuxième exemple de réalisation du procédé d'écriture selon l'invention permet, en appliquant un champ statique de composantes $H_X$ et $H_Y$ adaptées, uniformes ou quasi uniformes sur toute une mémoire MRAM, de donner la même orientation à toutes les régions magnétiques libres de tous les éléments mémoire du réseau. Un tel champ peut facilement être créé par des sources extérieures au circuit (aimant, électro-aimant). Une telle action peut être utile par exemple pour initialiser ou réinitialiser le fonctionnement d'une mémoire, par exemple au sortir de sa fabrication, ou pour effacer très vite la totalité d'une mémoire MRAM lorsque la sécurité d'une information en dépend.

Cette dernière méthode d'initialisation est aussi applicable de manière identique à une mémoire MRAM définie au sens du premier exemple de réalisation du procédé d'écriture selon l'invention, pourvu qu'il existe une différence de champ d'anisotropie effective planaire des couches ferromagnétiques de la région magnétique libre de l'élément mémoire compensé ou quasi compensé.

## Revendications

1. Elément mémoire magnétorésistif (16) comprenant une région magnétique piégée (22) et une région magnétique libre (18) séparées par une couche barrière (20), la région magnétique libre comprenant un empilement d'au moins deux couches ferromagnétiques (26, 28) couplées antiferromagnétiquement, à chaque couche étant associé un vecteur moment magnétique de couche ($\vec{\mu}_1$, $\vec{\mu}_2$), le vecteur moment magnétique résultant, égal à la somme des vecteurs moment magnétique de couche, ayant une amplitude inférieure à au moins 40% de l'amplitude du vecteur moment magnétique de couche d'amplitude maximale, dans lequel le champ d'anisotropie et/ou le tenseur de champ démagnétisant n'est pas identique pour les au moins deux couches ferromagnétiques d'où il résulte que les déviations angulaires ($\theta_1$, $\theta_2$) des vecteurs moment magnétique de couche sont différentes au moment de l'application d'un champ magnétique extérieur ($H_X$, $H_Y$).

2. Elément mémoire magnétorésistif selon la revendication 1, dans lequel la région magnétique libre comprend un empilement d'au moins deux paires de couches ferromagnétiques (26, 28) couplées antiferromagnétiquement, à chaque couche ferromagnétique étant associé un vecteur moment magnétique de couche ($\vec{\mu}_1$, $\vec{\mu}_2$), le vecteur moment magnétique résultant de chaque paire de couches, égal à la somme des vecteurs moment magnétique des couches ferromagnétiques de la paire de couches ferromagnétiques, ayant une amplitude inférieure à au moins 40% de l'amplitude du vecteur moment magnétique de couche d'amplitude maximale, les couches ferromagnétiques adjacentes des deux paires de couches ferromagnétiques étant couplées ferromagnétiquement, et dans lequel le champ d'anisotropie et/ou le tenseur de champ démagnétisant n'est pas identique pour les deux couches ferromagnétiques d'au moins une paire de couches ferromagnétiques, la disposition et les propriétés des couches ferromagnétiques dans chaque paire de couches ferromagnétiques étant adaptées pour que les vecteurs moment magnétique de couche ($\vec{\mu}_1$, $\vec{\mu}_2$) de deux couches ferromagnétiques adjacentes ferromagnétiquement couplées acquièrent des déviations angulaires ($\theta_1$, $\theta_2$) identiques au moment de l'application d'un champ magnétique extérieur ($H_X$, $H_Y$).

3. Elément mémoire magnétorésistif selon la revendication 1, dans lequel la région magnétique libre comprend un empilement d'au moins une première, une deuxième et une troisième couches ferromagnétiques (26, 28), les première et deuxième couches ferromagnétiques étant couplées antiferromagnétiquement, les deuxième et troisième couches ferromagnétiques étant couplées antiferromagnétiquement, à chacune des première, deuxième et troisième couches ferromagnétiques étant associé un vecteur moment magnétique de couche ($\vec{\mu}_1$, $\vec{\mu}_2$), le vecteur moment magnétique résultant, égal à la somme des vecteurs moment magnétique de couche des première, deuxième et troisième couches ferromagnétiques, ayant une amplitude inférieure à au moins 40% de l'amplitude du vecteur moment magnétique de la deuxième couche ferromagnétique et dans lequel les champs d'anisotropie et/ou les tenseurs de champ démagnétisant de la première ou troisième couche ferromagnétique et de la deuxième couche ferromagnétique sont différents d'où il résulte que les déviations angulaires des vecteurs moment magnétique de couche des première et troisième couches ferromagnétiques sont identiques et différents de la déviation angulaire de la deuxième couche ferromagnétique au moment de l'application d'un champ magnétique extérieur ($H_X$, $H_Y$).

4. Procédé d'écriture dans un élément mémoire (16) selon l'une quelconque des revendications 1 à 3, dans lequel le vecteur moment magnétique ($\vec{\mu}_1$) de la couche ferromagnétique (26) de la région magnétique libre (18) en contact avec la couche barrière (20) est orienté selon l'une des deux orientations opposées d'une direction privilégiée (OX), comprenant, de façon au moins partiellement simultanée, les étapes suivantes :

   - appliquer un premier champ magnétique ($H_X$) selon la direction privilégiée ; et
   - appliquer un second champ magnétique ($H_Y$) selon une direction (OY) sensiblement perpendiculaire à la direction privilégiée.

5. Procédé selon la revendication 4, dans lequel le tenseur de champ démagnétisant et/ou le champ d'anisotropie d'origine cristallographique n'est pas identique pour les au moins deux couches ferromagnétiques (26, 28), et dans lequel le second champ magnétique ($H_Y$) est appliqué, pendant l'application du premier champ magnétique ($H_X$), sous la forme d'une impulsion dont le temps de montée est inférieur à la moitié de la période de précession la plus faible des au moins deux couches ferromagnétiques.

6. Procédé selon la revendication 4, dans lequel les champs d'anisotropie effectifs planaires des au moins deux couches ferromagnétiques (26, 28) couplées antiferromagnétiquement ont des amplitudes différentes et dans lequel les premier et second champs magnétiques ($H_X$, $H_Y$) sont appliqués simultanément pendant une durée supérieure aux temps de relaxation des vecteurs moment magnétique de couche ($\vec{\mu}_1$, $\vec{\mu}_2$) des au moins deux couches ferromagnétiques (26, 28) couplées antiferromagnétiquement de la région magnétique libre (18) vers des positions d'équilibre respectives déterminées.

7. Procédé selon la revendication 6, dans lequel l'amplitude du second champ magnétique ($H_Y$) est inférieure à la moitié de l'amplitude du premier champ magnétique ($H_X$).

8. Procédé selon la revendication 6, dans lequel les instants de mise en place et/ou les durées d'application des premier et second champs magnétiques ($H_X$, $H_Y$) sont différents.

9. Procédé selon la revendication 6, dans lequel les premier et second champs magnétiques ($H_X$, $H_Y$) sont appliqués de manière globale à une mémoire (10) constituée d'éléments mémoire (16) selon l'une quelconque des revendications 1 à 3, en utilisant une source de champ magnétique extérieure à la mémoire, d'où il résulte l'initialisation de la mémoire.

10. Procédé selon la revendication 6, dans lequel les premier et second champs magnétiques ($H_X$, $H_Y$) sont appliqués de manière globale à une mémoire (10) constituée d'éléments mémoire (16) selon l'une quelconque des revendications 1 à 3, en utilisant une source de champ magnétique extérieure à la mémoire, d'où il résulte l'effacement complet de la mémoire.

Fig 1

Fig 2

Fig 3

Fig 4

Fig 5

Fig 6

Fig 7

Fig 8A

Fig 8B

Fig 8C

Fig 9

Fig 10

Fig 11A

Fig 11B

Fig 11C

Fig 12A

Fig 12B

Fig 12C

Fig 13

Fig 14A

Fig 14B

Fig 15A

Fig 15B

**Office européen
des brevets**

**RAPPORT DE RECHERCHE EUROPEENNE**

Numéro de la demande

EP 05 10 3286

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | US 5 953 248 A (CHEN EUGENE ET AL) 14 septembre 1999 (1999-09-14) | 1,4 | G11C11/16 |
| A | * le document en entier * ----- | 5-10 | |
| X | US 2003/072174 A1 (JANESKY JASON ALLEN ET AL) 17 avril 2003 (2003-04-17) | 1 | |
| A | * alinéa [0035] - alinéa [0048] * ----- | 2-10 | |

|  |  |
|---|---|
| | DOMAINES TECHNIQUES RECHERCHES (Int.Cl.7) |
| | G11C |

Le présent rapport a été établi pour toutes les revendications

| Lieu de la recherche | Date d'achèvement de la recherche | Examinateur |
|---|---|---|
| La Haye | 13 mai 2005 | Degraeve, L |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons
.................................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 05 10 3286

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

13-05-2005

| Document brevet cité au rapport de recherche | | Date de publication | Membre(s) de la famille de brevet(s) | | Date de publication |
|---|---|---|---|---|---|
| US 5953248 | A | 14-09-1999 | EP | 1038299 A1 | 27-09-2000 |
| | | | JP | 2002520873 T | 09-07-2002 |
| | | | TW | 451192 B | 21-08-2001 |
| | | | WO | 0004552 A1 | 27-01-2000 |
| US 2003072174 | A1 | 17-04-2003 | EP | 1474807 A2 | 10-11-2004 |
| | | | JP | 2005505889 T | 24-02-2005 |
| | | | TW | 583666 B | 11-04-2004 |
| | | | WO | 03034437 A2 | 24-04-2003 |
| | | | US | 2003128603 A1 | 10-07-2003 |

EPO FORM P0460

Pour tout renseignement concernant cette annexe : voir Journal Officiel de l'Office européen des brevets, No.12/82